# EUROPEAN PATENT APPLICATION

(11) **EP 4 525 595 A1**
(43) Date of publication of application: **19.03.2025**
(21) Application number: 23803402.9
(22) Date of filing: 24.04.2023
(51) Int. Cl.: H10N 10/10, F21V 29/54, F25B 21/02, G03B 21/14, G03B 21/16, H01L 23/38

(54) **PELTIER ELEMENT CONTROL DEVICE, ELECTRICAL DEVICE AND CONTROL METHOD**

(30) Priority: 09.05.2022 JP 2022077120
(71) Applicant: Panasonic Intellectual Property Management Co., Ltd., Osaka-shi, Osaka 540-6207 (JP)
(72) Inventor: YAMAMOTO, Shota, Kadoma-shi, Osaka 571-0057 (JP)
(74) Representative: Eisenführ Speiser
(86) International application number: PCT/JP2023/016048
(87) International publication number: WO 2023/218920

(57) **Abstract**

A Peltier element control device includes a drive circuit, a voltage detector, and a control circuit. The drive circuit supplies a current to the Peltier element. The voltage detector detects a voltage value of a voltage applied to the Peltier element. The control circuit causes the drive circuit to supply a current of a predetermined constant value to the Peltier element, and causes the drive circuit to reduce a magnitude of the current supplied to the Peltier element in a case where a value related to the voltage value detected when the current of the predetermined constant value is supplied to the Peltier element increases.

## Description

### TECHNICAL FIELD

The present disclosure relates to a Peltier element control device, an electrical device, and a control method.

### BACKGROUND ART

A Peltier element may be used to cool a heat source included in an electrical device. The Peltier element moves heat from a heat absorbing surface to a heat dissipating surface in accordance with a flowing current.

For example, Patent Literature (PTL) 1 discloses a Peltier element driving method capable of driving a Peltier element by using a power supply having a necessary and sufficient current capacity with respect to a steady current.

### Citation List

### Patent Literature

PTL 1: Unexamined Japanese Patent Publication No. 2000-353830

### SUMMARY OF THE INVENTION

The amount of heat moved from the heat absorbing surface to the heat dissipating surface by the Peltier element is proportional to a magnitude of a current flowing through the Peltier element. However, as the current flowing through the Peltier element increases, Joule heat generated by an electric resistance of the Peltier element increases. In addition, in a case where the heat dissipating surface is insufficiently cooled, the generated Joule heat cannot be sufficiently moved, a temperature of the heat absorbing surface rises, and a larger current is required for the Peltier element in order to cool the heat absorbing surface. Accordingly, in a case where the heat dissipating surface of the Peltier element is insufficiently cooled, the heat source cannot be cooled by the Peltier element, and the Peltier element itself may generate heat and cause thermal runaway. Thus, it is necessary to control the Peltier element such that thermal runaway hardly occurs.

An object of the present disclosure is to provide a Peltier element control device and a control method capable of controlling a Peltier element such that thermal runaway hardly occurs with a simpler configuration than in the related art. Another object of the present disclosure is to provide an electrical device including such a Peltier element control device.

In accordance with one aspect of the present disclosure, a Peltier element control device that controls a Peltier element includes a drive circuit that supplies a current to the Peltier element, a voltage detector that detects a voltage value of a voltage applied to the Peltier element, and a control circuit that causes the drive circuit to supply a current of a predetermined constant value to the Peltier element, and causes the drive circuit to reduce a magnitude of the current supplied to the Peltier element in a case where a value related to the voltage value detected when the current of the predetermined constant value is supplied to the Peltier element increases.

In accordance with one aspect of the present disclosure, it is possible to control the Peltier element such that thermal runaway hardly occurs with a simpler configuration than in the related art.

### BRIEF DESCRIPTION OF THE DRAWINGS

Fig. 1 is a block diagram illustrating a configuration of Peltier element control device 1 according to a first exemplary embodiment.
Fig. 2 is a diagram schematically illustrating current-voltage characteristics of Peltier element 3 in a case where a temperature difference between heat absorbing surface 3a and heat dissipating surface 3b of Peltier element 3 in Fig. 1 is 10°C.
Fig. 3 is a diagram schematically illustrating current-voltage characteristics of Peltier element 3 in a case where the temperature difference between heat absorbing surface 3a and heat dissipating surface 3b of Peltier element 3 in Fig. 1 is 40°C.
Fig. 4 is a diagram schematically illustrating a current flowing through Peltier element 3 and a voltage applied to Peltier element 3 in a case where heat dissipating surface 3b of Peltier element 3 in Fig. 1 is sufficiently cooled.
Fig. 5 is a diagram schematically illustrating a current flowing through Peltier element 3 and a voltage applied to Peltier element 3 in a case where heat dissipating surface 3b of Peltier element 3 in Fig. 1 is not sufficiently cooled, and illustrating a first example in which control circuit 13 controls drive circuit 11.
Fig. 6 is a diagram schematically illustrating a current flowing through Peltier element 3 and a voltage applied to Peltier element 3 in a case where heat dissipating surface 3b of Peltier element 3 in Fig. 1 is not sufficiently cooled, and illustrating a second example in which control circuit 13 controls drive circuit 11.
Fig. 7 is a block diagram illustrating a configuration of video projection device 20 including Peltier element control device 1 according to the first exemplary embodiment.
Fig. 8 is a block diagram illustrating a configuration of Peltier element control device 1A according to a second exemplary embodiment.
Fig. 9 is a block diagram illustrating a configuration of video projection device 20A including Peltier element control device 1A according to the second exemplary embodiment.

### DESCRIPTION OF EMBODIMENT

Exemplary embodiments will now be described below in detail with reference to the drawings as appropriate. However, unnecessarily detailed description may be omitted. For example, detailed descriptions of already well-known matters and the redundant description of substantially identical configurations may be omitted. This is to avoid unnecessary redundancy of the following description and to facilitate understanding of those skilled in the art.

Note that the inventor provides the attached drawings and the following description to help those skilled in the art fully understand the present disclosure, and does not intend to limit the subject matter described in the appended claims to these.

### [First exemplary embodiment]

### [Configuration of first exemplary embodiment]

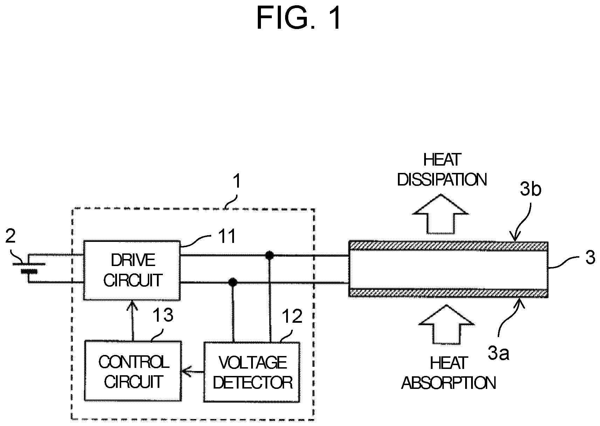

Fig. 1 is a block diagram illustrating a configuration of Peltier element control device 1 according to a first exemplary embodiment. Peltier element control device 1 controls Peltier element 3 by receiving power supply from DC power supply device 2.

Peltier element control device 1 includes drive circuit 11, voltage detector 12, and control circuit 13. Drive circuit 11 receives power supply from DC power supply device 2 and supplies a current to Peltier element 3 under the control of control circuit 13. Voltage detector 12 detects a voltage value of a voltage applied to Peltier element 3. Control circuit 13 controls drive circuit 11 based on the detected voltage value. For example, drive circuit 11 is a constant current drive circuit, and control circuit 13 controls drive circuit 11 to supply a current of a predetermined constant value to Peltier element 3.

Peltier element 3 has heat absorbing surface 3a and heat dissipating surface 3b, and moves heat from heat absorbing surface 3a to heat dissipating surface 3b in accordance with a flowing current. Heat absorbing surface 3a is disposed to come into contact with any heat source. Heat dissipating surface 3b may be disposed to come into contact with a radiator, and may be cooled by a cooling device such as a fan.

### [Operation of first exemplary embodiment]

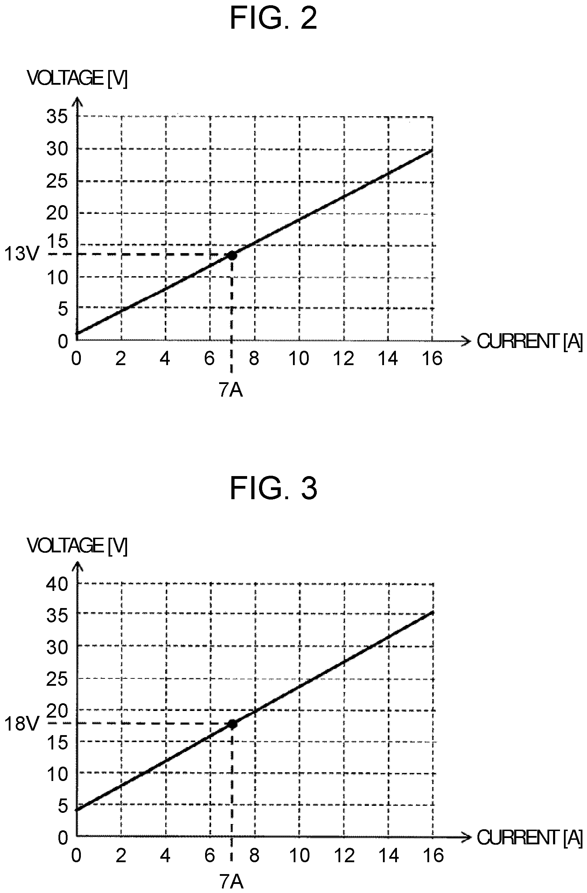

Fig. 2 is a diagram schematically illustrating current-voltage characteristics of Peltier element 3 in a case where a temperature difference between heat absorbing surface 3a and heat dissipating surface 3b of Peltier element 3 in Fig. 1 is 10°C. Fig. 3 is a diagram schematically illustrating current-voltage characteristics of Peltier element 3 in a case where the temperature difference between heat absorbing surface 3a and heat dissipating surface 3b of Peltier element 3 in Fig. 1 is 40°C. Fig. 2 illustrates a case where a temperature of heat absorbing surface 3a is 35°C and a temperature of heat dissipating surface 3b is 45°C. Fig. 3 illustrates a case where the temperature of heat absorbing surface 3a is 35°C and the temperature of heat dissipating surface 3b is 75°C. A voltage that needs to be applied to Peltier element 3 in order to cause a current having a predetermined magnitude to flow through Peltier element 3 varies depending on the temperature difference between heat absorbing surface 3a and heat dissipating surface 3b. As the temperature difference increases, it is necessary to apply a higher voltage. For example, in order to cause a current of 7 A to flow through Peltier element 3, it is necessary to apply a voltage of 13 V to Peltier element 3 in the example of Fig. 2, and it is necessary to apply a voltage of 18 V to Peltier element 3 in the example of Fig. 3. Accordingly, in a case where constant current control is performed on Peltier element 3, the temperature difference between heat absorbing surface 3a and heat dissipating surface 3b can be estimated by detecting the voltage applied to Peltier element 3.

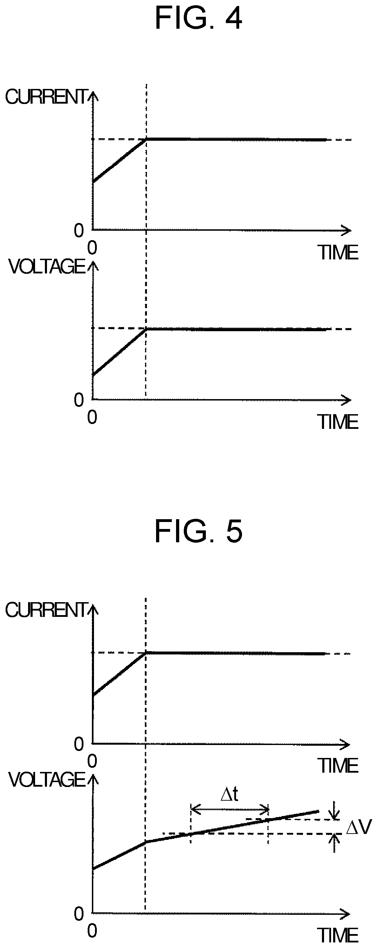

Fig. 4 is a diagram schematically illustrating the current flowing through Peltier element 3 and the voltage applied to Peltier element 3 in a case where heat dissipating surface 3b of Peltier element 3 in Fig. 1 is sufficiently cooled. In a case where the heat source can be satisfactorily cooled by using Peltier element 3, the temperature difference between heat absorbing surface 3a and heat dissipating surface 3b is a constant small value, and the voltage applied to Peltier element 3 is also a constant value. Accordingly, in a case where the voltage applied to Peltier element 3 is a constant value, it can be determined that the heat source can be satisfactorily cooled.

Fig. 5 schematically illustrates the current flowing through Peltier element 3 and the voltage applied to Peltier element 3 in a case where heat dissipating surface 3b of Peltier element 3 in Fig. 1 is not sufficiently cooled, and is a diagram illustrating a first example in which control circuit 13 controls drive circuit 11. In a case where heat dissipating surface 3b is insufficiently cooled, since the temperature of heat dissipating surface 3b rapidly increases, the temperature difference between heat absorbing surface 3a and heat dissipating surface 3b rapidly increases, and the voltage applied to Peltier element 3 also rapidly increases. Accordingly, in a case where the voltage applied to Peltier element 3 rapidly increases, it can be determined that heat dissipating surface 3b is insufficiently cooled and Peltier element 3 may thermally run away.

Accordingly, in accordance with Peltier element control device 1 according to the present exemplary embodiment, in a case where a value related to the voltage value detected by voltage detector 12 when the current of the constant value is supplied to Peltier element 3 increases, control circuit 13 controls drive circuit 11 to reduce the magnitude of the current supplied to Peltier element 3. Specifically, for example, as illustrated in Fig. 5, in a case where temporal change rate ΔV/Δt of the detected voltage value is larger than a predetermined threshold value (threshold value of a change rate of the voltage value), control circuit 13 controls drive circuit 11 to reduce the magnitude of the current supplied to Peltier element 3 or stop the current supplied to Peltier element 3. The threshold value in this case may be set to 0.05 V/s, for example, in a case where Peltier element 3 has characteristics illustrated in Figs. 2 and 3. The temporal change rate of the voltage value is an example of the value related to the voltage value.

In accordance with Peltier element control device 1 according to the present exemplary embodiment, the temperature difference between heat absorbing surface 3a and heat dissipating surface 3b can be estimated by detecting the voltage applied to Peltier element 3, and a change in temperature of heat dissipating surface 3b can be indirectly detected. In accordance with Peltier element control device 1 according to the present exemplary embodiment, since a temperature sensor is unnecessary, the size and cost of the device are further reduced than in the related art. Accordingly, in accordance with Peltier element control device 1 according to the present exemplary embodiment, it is possible to control Peltier element 3 such that thermal runaway hardly occurs with a simpler configuration than in the related art.

In a case where the Peltier element is to be protected from thermal runaway based on the current flowing through the Peltier element, the Peltier element cannot necessarily be protected under the condition in which thermal runaway occurs. The thermal runaway of the Peltier element occurs due to insufficient cooling performance on the heat dissipating surface. In accordance with Peltier element control device 1 according to the present exemplary embodiment, since a temperature rise on heat dissipating surface 3b, which causes thermal runaway, can be indirectly detected, Peltier element 3 can be reliably protected under the condition in which thermal runaway occurs. In addition, in accordance with Peltier element control device 1 according to the present exemplary embodiment, since the temperature of heat dissipating surface 3b can be estimated, in a case where the heat dissipating surface is liquid-cooled by a liquid-cooling type cooling device, a temperature of a cooling liquid can be maintained at a temperature less than or equal to a maximum value in the specification, and thus, the reliability of the cooling device can be secured.

A change in voltage applied to Peltier element 3 can be detected more quickly than a change in temperature of Peltier element 3 detected by the temperature sensor. Accordingly, in accordance with Peltier element control device 1 according to the present exemplary embodiment, the voltage applied to Peltier element 3 is detected, and thus, the change in temperature of heat dissipating surface 3b can be detected more quickly than in a case where the temperature sensor is used.

### [Another example of first exemplary embodiment]

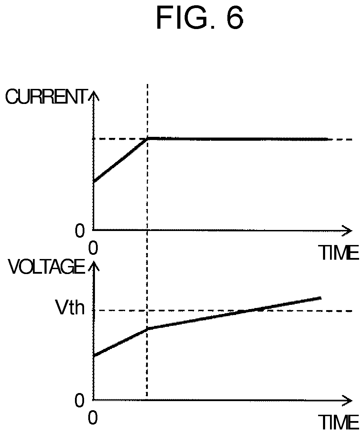

Fig. 6 schematically illustrates the current flowing through Peltier element 3 and the voltage applied to Peltier element 3 in a case where heat dissipating surface 3b of Peltier element 3 of Fig. 1 is not sufficiently cooled, and is a diagram illustrating a second example in which control circuit 13 controls drive circuit 11. Control circuit 13 may control drive circuit 11 to reduce the magnitude of the current supplied to Peltier element 3 or stop the current supplied to Peltier element 3 in a case where the voltage value detected by voltage detector 12 is larger than predetermined threshold value Vth (threshold value of the voltage value) when the current of the constant value is supplied to Peltier element 3. For example, in a case where Peltier element 3 has characteristics illustrated in Figs. 2 and 3, threshold value Vth may be set to 18 V. The voltage value is an example of the value related to the voltage value.

Control circuit 13 may control drive circuit 11 by using both the threshold value of the change rate of the voltage value described with reference to Fig. 5 and the threshold value of the voltage value described with reference to Fig. 6.

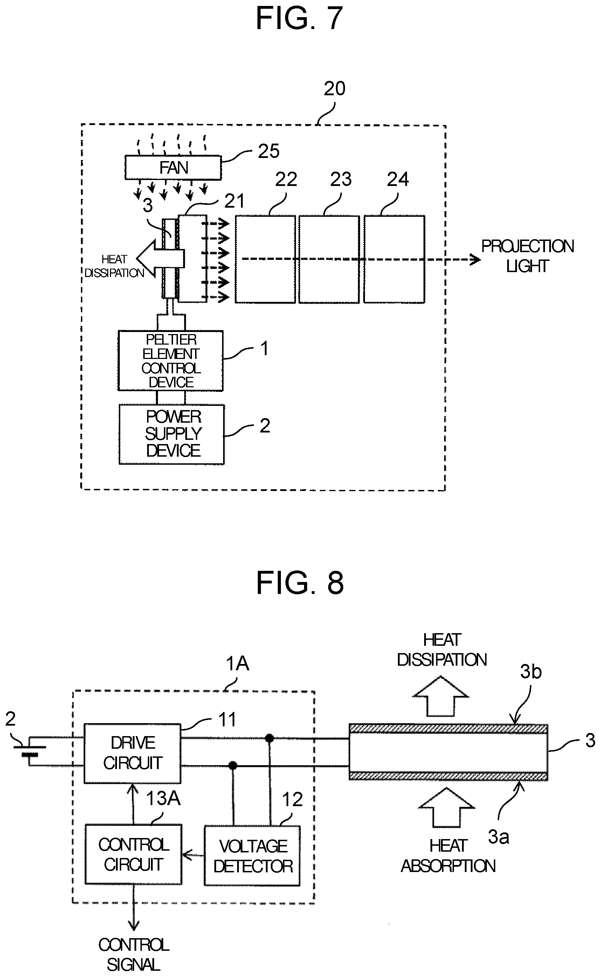

Fig. 7 is a block diagram illustrating a configuration of video projection device 20 including Peltier element control device 1 according to the first exemplary embodiment. Video projection device 20 includes Peltier element control device 1, power supply device 2, Peltier element 3, light source device 21, illumination optical system 22, light modulation device 23, projection optical system 24, and fan 25. Light source device 21 includes a light source element such as a laser diode, and generates light of a predetermined wavelength such as red light and blue light. Since light source device 21 generates light and operates as the heat source, light source device 21 is cooled by using Peltier element 3. Peltier element control device 1, power supply device 2, and Peltier element 3 in Fig. 7 have configurations similar to the corresponding components in Fig. 1. Heat absorbing surface 3a of Peltier element 3 is provided to come into contact with light source device 21. Illumination optical system 22 transmits the light generated by light source device 21 to light modulation device 23. Light modulation device 23 includes a light modulation element such as a digital micromirror device (DMD), and spatially modulates light incident from illumination optical system 22. Projection optical system 24 projects the light modulated by light modulation device 23 onto a screen. Fan 25 is disposed to cool heat dissipating surface 3b of Peltier element 3. As addition or alternative to fan 25, a liquid-cooling type cooling device coming into contact with heat dissipating surface 3b of Peltier element 3 may be provided. As described above, Peltier element control device 1 controls Peltier element 3 such that thermal runaway hardly occurs.

In general, when a periphery of the video projection device is surrounded by an enclosure or the like, an exhaust port of a radiator for cooling is hindered, and cooling performance deteriorates as compared with a case without the enclosure. In this case, the Peltier element cannot be cooled to be less than or equal to a predetermined temperature, and a possibility of thermal runaway of the Peltier element increases. In the related art, some video projection devices have a protection function of stopping the current flowing through the Peltier element when a predetermined maximum current flows through the Peltier element for a predetermined period, for example, in order to operate the liquid-cooling type cooling device at a temperature less than or equal to a maximum value in the specification of the cooling liquid. This protection function often operates even though the temperature of the heat dissipating surface of the Peltier element does not exceed the maximum value in the specification of the protection function. On the other hand, in accordance with Peltier element control device 1 according to the present exemplary embodiment, since the change in temperature of heat dissipating surface 3b of Peltier element 3 to be originally detected is indirectly detected and Peltier element 3 is controlled based on this information, unnecessary stop of the current flowing through the Peltier element can be prevented.

Peltier element control device 1 according to the present exemplary embodiment is applicable not only to video projection device 20 but also to any electrical device including a heat source.

### [Effects of first exemplary embodiment]

In accordance with Peltier element control device 1 of one aspect of the present disclosure, Peltier element control device 1 that controls Peltier element 3 includes drive circuit 11, voltage detector 12, and control circuit 13. Drive circuit 11 supplies a current to Peltier element 3. Voltage detector 12 detects a voltage value of a voltage applied to Peltier element 3. Control circuit 13 causes drive circuit 11 to supply a current of the predetermined constant value to Peltier element 3, and causes drive circuit 11 to reduce a magnitude of the current supplied to Peltier element 3 in a case where the value related to the voltage value detected when the current of the predetermined constant value is supplied to Peltier element 3 increases.

As a result, it is possible to control Peltier element 3 such that thermal runaway hardly occurs with a simpler configuration than in the related art.

In accordance with Peltier element control device 1 according to one aspect of the present disclosure, control circuit 13 may cause drive circuit 11 to reduce the magnitude of the current supplied to Peltier element 3 in a case where a temporal change rate of the voltage value detected when the current of the predetermined constant value is supplied to Peltier element 3 is larger than a first threshold value.

As a result, the temperature difference between heat absorbing surface 3a and heat dissipating surface 3b can be estimated, and the change in temperature of heat dissipating surface 3b can be indirectly detected.

In accordance with Peltier element control device 1 according to one aspect of the present disclosure, control circuit 13 may cause drive circuit 11 to reduce the magnitude of the current supplied to Peltier element 3 in a case where the voltage value detected when the current of the predetermined constant value is supplied to Peltier element 3 is larger than a second threshold value.

As a result, the temperature difference between heat absorbing surface 3a and heat dissipating surface 3b can be estimated, and the change in temperature of heat dissipating surface 3b can be indirectly detected.

In accordance with an electrical device according to one aspect of the present disclosure includes a heat source, Peltier element 3 coming into contact with the heat source, and Peltier element control device 1 according to the aspect described above.

As a result, it is possible to control Peltier element 3 such that thermal runaway hardly occurs with a simpler configuration than in the related art.

In accordance with an electrical device according to one aspect of the present disclosure, the electrical device may be video projection device 20. In this case, the heat source may be light source device 21.

As a result, for example, in order to cool a red laser diode of light source device 21 which is the heat source of the video projection device, Peltier element 3 can be controlled such that thermal runaway hardly occurs.

In accordance with a control method for controlling Peltier element 3 according to one aspect of the present disclosure includes a step of supplying a current of a predetermined constant value to Peltier element 3, a step of detecting a voltage value of a voltage applied to Peltier element 3, and a step of reducing a magnitude of the current supplied to Peltier element 3 in response to an increase in value related to the voltage value detected when the current of the predetermined constant value is supplied to Peltier element 3.

As a result, it is possible to control Peltier element 3 such that thermal runaway hardly occurs with a simpler configuration than in the related art.

### [Second exemplary embodiment]

Fig. 8 is a block diagram illustrating a configuration of Peltier element control device 1A according to a second exemplary embodiment. Peltier element control device 1A includes control circuit 13A instead of control circuit 13 in Fig. 1. Control circuit 13A may generate a control signal for controlling a cooling device separate from Peltier element 3. In a case where a value related to the voltage value detected by voltage detector 12 when a current of a constant value is supplied to Peltier element 3 increases, control circuit 13A sends a control signal for improving cooling performance of the cooling device to the cooling device. For example, in a case where the cooling device includes a fan, the cooling performance may be improved by increasing a rotational speed of the fan.

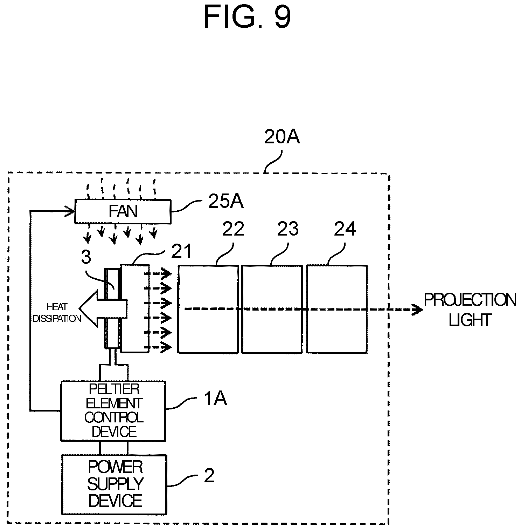

Fig. 9 is a block diagram illustrating a configuration of video projection device 20A including Peltier element control device 1A according to the second exemplary embodiment. Video projection device 20A includes Peltier element control device 1A and fan 25A instead of Peltier element control device 1 and fan 25 in Fig. 7. Fan 25A operates according to Peltier element control device 1A.

In a case where the value related to the voltage value detected by voltage detector 12 when the current of the constant value is supplied to Peltier element 3 increases, control circuit 13A of Fig. 8 may control drive circuit 11 to reduce the magnitude of the current supplied to Peltier element 3, and may send the control signal for improving the cooling performance of the cooling device to the cooling device. As a result, it is possible to cool Peltier element 3 to a temperature at which Peltier element 3 can be operated again in a short time while reliably avoiding the thermal runaway of Peltier element 3. Alternatively, in a case where the value related to the detected voltage value increases, control circuit 13A may send the control signal for improving the cooling performance of the cooling device to the cooling device while maintaining the magnitude of the current supplied to Peltier element 3. As a result, it is possible to set the thermal runaway to hardly occur while operating Peltier element 3.

### [Effects of second exemplary embodiment]

In accordance with the electrical device according to one aspect of the present disclosure, the electrical device may further include the cooling device that is configured to lower a temperature of the heat source and separate from Peltier element 3. In this case, in a case where a value related to the voltage value detected when the current of the predetermined constant value is supplied to Peltier element 3 increases, control circuit 13A sends a control signal for improving cooling performance of the cooling device to the cooling device.

As a result, it is possible to cool Peltier element 3 to a temperature at which Peltier element 3 can be operated again in a short time while reliably avoiding the thermal runaway of Peltier element 3.

### [Other exemplary embodiments]

The exemplary embodiments have been described as examples of the technique disclosed in the present application. However, the technique in the present disclosure is not limited to the exemplary embodiments and is applicable to exemplary embodiments appropriately subjected to changes, replacements, additions, omissions, and the like. It is also possible to combine the components described in the above-described exemplary embodiments to form a new exemplary embodiment.

As described above, the exemplary embodiments have been described as examples of the technique in the present disclosure. For this purpose, the accompanying drawings and the detailed description have been provided.

Thus, the components described in the accompanying drawings and the detailed description include not only the components essential for solving the problem but also components that are not essential for solving the problem to exemplify the technique described above. Therefore, it should not be immediately recognized that these non-essential constituent elements are essential based on the fact that these non-essential constituent elements are described in the accompanying drawings and the detailed description.

The above-described exemplary embodiments are intended to exemplify the technique in the present disclosure, and thus various changes, replacements, additions, omissions, and the like can be made to the exemplary embodiments within the scope of the claims or equivalents of the claims.

### INDUSTRIAL APPLICABILITY

A Peltier element control device according to one aspect of the present disclosure is applicable to an electrical device such as a video projection device.

### REFERENCE MARKS IN THE DRAWINGS

- 1, 1A:: Peltier element control device

- 2:: power supply device
- 3:: Peltier element
- 3a:: heat absorbing surface
- 3b:: heat dissipating surface
- 11:: drive circuit
- 12:: voltage detector
- 13, 13A:: control circuit
- 20, 20A:: video projection device
- 21:: light source device
- 22:: illumination optical system
- 23:: light modulation device
- 24:: projection optical system
- 25, 25A:: fan

## Claims

1. A Peltier element control device that controls a Peltier element, the device comprising:
a drive circuit that supplies a current to the Peltier element;
a voltage detector that detects a voltage value of a voltage applied to the Peltier element; and
a control circuit that causes the drive circuit to supply a current of a predetermined constant value to the Peltier element, and causes the drive circuit to reduce a magnitude of the current supplied to the Peltier element in a case where a value related to the voltage value detected when the current of the predetermined constant value is supplied to the Peltier element increases.

2. The Peltier element control device according to Claim 1, wherein, in a case where a temporal change rate of the voltage value detected when the current of the predetermined constant value is supplied to the Peltier element is larger than a first threshold value, the control circuit causes the drive circuit to reduce the magnitude of the current supplied to the Peltier element.

3. The Peltier element control device according to Claim 1, wherein, in a case where the voltage value detected when the current of the predetermined constant value is supplied to the Peltier element is larger than a second threshold value, the control circuit causes the drive circuit to reduce the magnitude of the current supplied to the Peltier element.

4. An electrical device comprising:
a heat source;
a Peltier element coming into contact with the heat source; and
the Peltier element control device according to any one of Claims 1 to 3.

5. The electrical device according to Claim 4, further comprising:
a cooling device configured to lower a temperature of the heat source and separate from the Peltier element,
wherein the control circuit sends a control signal for improving cooling performance of the cooling device to the cooling device in a case where a value related to the voltage value detected when the current of the predetermined constant value is supplied to the Peltier element increases.

6. The electrical device according to Claim 4,
wherein the electrical device is a video projection device, and
the heat source is a light source device.

7. A control method for controlling a Peltier element, comprising:
supplying a current of a predetermined constant value to the Peltier element;
detecting a voltage value of a voltage applied to the Peltier element; and
reducing a magnitude of the current supplied to the Peltier element in response to an increase in value related to the voltage value detected when the current of the predetermined constant value is supplied to the Peltier element.
